## Europäisches Patentamt

## European Patent Office

## Office européen des brevets

(19)

(11) Veröffentlichungsnummer: **0 116 654**
**B1**

(12) **EUROPÄISCHE PATENTSCHRIFT**

(45) Veröffentlichungstag der Patentschrift:
**10.12.86**

(21) Anmeldenummer: **83101346.1**

(22) Anmeldetag: **12.02.83**

(51) Int. Cl.⁴: **H 01 L 21/00,** H 01 L 21/265

(54) Verfahren zum Herstellen von bipolaren Planartransistoren.

(43) Veröffentlichungstag der Anmeldung:
**29.08.84 Patentblatt 84/35**

(45) Bekanntmachung des Hinweises auf die Patenterteilung:
**10.12.86 Patentblatt 86/50**

(84) Benannte Vertragsstaaten:
**DE FR GB IT NL**

(56) Entgegenhaltungen:
EP - A - 0 071 665
GB - A - 2 056 167
US - A - 4 347 654

**PATENT ABSTRACTS OF JAPAN, Band 6, Nr.
12(E-91)(890), 23 January 1982**

(73) Patentinhaber: **Deutsche ITT Industries GmbH,
Hans-Bunte-Strasse 19 Postfach 840, D-7800 Freiburg
(DE)**
(84) Benannte Vertragsstaaten: **DE**

(73) Patentinhaber: **ITT INDUSTRIES INC., 320 Park Avenue,
New York, NY 10022 (US)**
(84) Benannte Vertragsstaaten: **FR GB IT NL**

(72) Erfinder: **Blossfeld, Lothar, Dipl.-Phys., Waldstrasse 23,
D-7800 Freiburg-Hochdorf (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

## Beschreibung

Die Erfindung betrifft ein Verfahren gemäss dem Oberbegriff des Anspruchs 1, wie es aus «Genschow, Technischer Informationsdienst, Sonderausgabe Halbleiter», (April 1972) bekannt ist.

Das bekannte Verfahren hat den Nachteil, dass die Stromverstärkungswerte der Transistoren, welche bekanntlich in der Mehrzahl in einer in die Festkörperschaltung zu zerteilenden Halbleiterplatte hergestellt werden, von Platte zu Platte Schwankungen unterworfen sind.

Die Erfindung geht von der Erkenntnis aus, dass Schwankungen der genannten Stromverstärkungswerte (B-Werte) um wenige Prozent möglich werden, wenn die Herstellungsprozesse derart ausgewählt und geführt werden, dass die Geasamtladungsträgermenge in den intrinsischen Basiszonen, d.h. in dem Bereich der Basiszone unter der Emitterzone, sowohl möglich exakt steuerbar, als auch nicht kompensierte Emitterzonen verwendet werden. Eine nichtkompensierte Emitterzone hat nach «1979 Intern. Electron. Dev. Meeting, Techn. Digest», Seiten 514 bis 517, nämlich den Vorteil, dass relativ grosse Stromverstärkungswerte und erhöhte Grenzfrequenzen möglich sind. Es wurde festgestellt, dass solche Emitterzonen ebenfalls die Rauscharmut fördern.

Aufgabe der Erfindung ist daher die Angabe eines Verfahrens zum Herstellen von bipolaren Planartransistoren an einer in die einzelnen Planartransistoren zu zerteilenden n-leitenden Halbleiterplatte gemäss dem Oberbegriff des Anspruchs 1, welches es erlaubt, die Streuung der Stromverstärkungswerte der Planartransistoren über die Halbleiterplatten auf ein Minimum zu bringen.

Diese Aufgabe wird erfindungsgemäss durch die im kennzeichnenden Teil des Anspruchs 1 angegebenen Massnahmen gelöst.

Als Material für die Oxidationsmaskierungsschicht wird vorzugsweise Siliciumnitrid oder auch eine mit einer Siliciumnitridschicht abgedeckte Schicht aus Siliciumdioxid verwendet. In diesem Fall eignet sich als Material für die Ätzmaskierungsschicht, mit der der äussere Basisbereich abgedeckt wird, eine Schicht aus Siliciumdioxid, welches beispielsweise gegen die als Ätzmittel von Siliciumnitrid bekannte heisse Phosphorsäure praktisch nicht ätzbar ist.

Zum Stand der Technik nach Art 54(3) EPÜ gehört für die benannten Vertragsstaaten aufgrund der europäischen Patentanmeldung EP-A-0 071 665 ein Verfahren zum Herstellen einer monolitisch integrierten Festkörperschaltung mit mindestens einem bipolaren Planartransistor, dessen Emitterzone an einer Oberflächenseite eines halbleitenden Substrats an eine Basiszone angrenzt. Bei diesem Verfahren werden zwar ebenfalls der Emitterbereich mit einem Oxidationsmaskierungsschichtteil bedeckt, danach eine den Basisbereich definierende Photolackmaske erzeugt und anschliessend in die freiliegenden äusseren extrinsischen Basisbereiche bei einer relativ geringen Beschleunigungsspannung und relativ hoher Dosis p-dotierende Ionen implantiert und mit geringer Dosis Ionen gleichen Leitungstyps in die freiliegenden extrinsischen Basisbereiche und in die übrigen Bereiche der Gesamt-Basisbereiche bei einer so grossen Beschleunigungsspannung implantiert, dass die Emitterbereiche bedeckende Oxidationsmaskierungsschichtteile durchdrungen werden. Sodann werden nach Abätzung der Oxidationsmaskierungsschichtteile Dotierungen vom Leitungstyp der Emitterzonen implantiert und sowohl die Basiszonen als auch die Emitterzonen unter Aktivierung der Dotierungen diffundiert. Bei diesem Verfahren handelt es sich jedoch um die Herstellung einer monolithisch integrierten Festkörperschaltung, wobei mittels maskierender Ionenimplantation die Dotierung der Kollektorzonen in die Oberflächenseite einer in die einzelnen monolitisch integrierten Festkörperschaltungen zu erteilenden Halbleiterplatte eingebracht und eindiffundiert werden. An die Herstellung von bipolaren Planartransistoren an einer in die einzelnen Planartransistoren zu zerteilenden Halbleiterplatte ist dabei nicht gedacht worden.

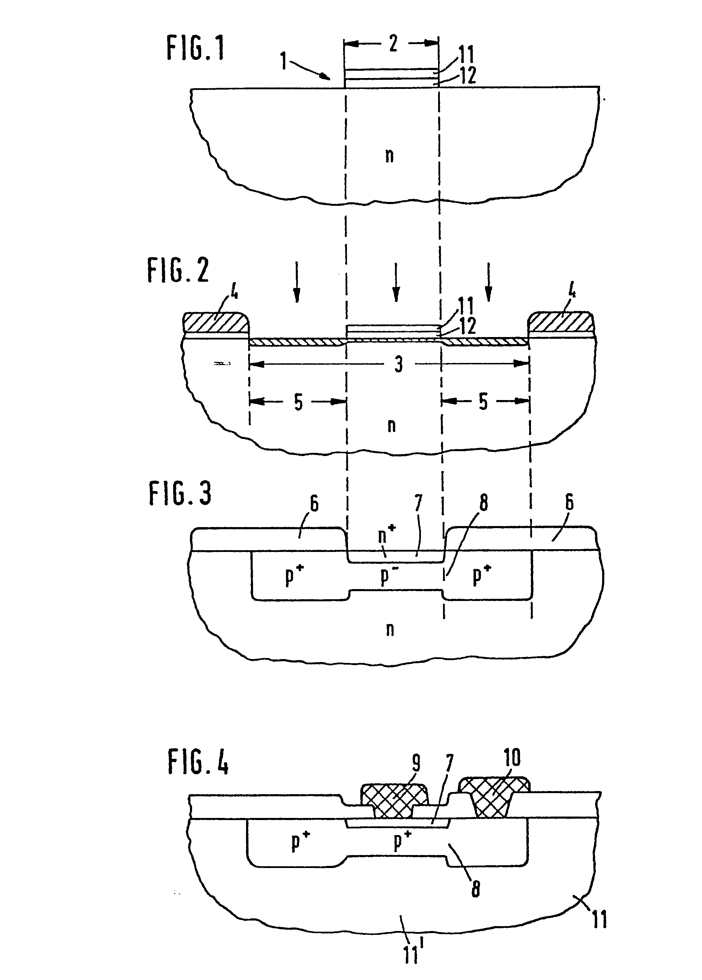

Das Verfahren nach der Erfindung und ihre Vorteile werden im folgenden an Ausführungsbeispielen erklärt, welche anhand der Zeichnung erläutert werden, deren Fig. 1 bis 4 in üblicher Darstellung ausschnittweise Querschnittansichten etwa senkrecht zur Hauptfläche eines plattenförmigen Halbleiterkörper zeigen, welche zur Erläuterung eines Ausführungsbeispiels des Verfahrens nach der Erfindung dienen.

Bei dem Ausführungsbeispiel des Verfahrens nach der Erfindung wird gemäss der Fig. 1 von einem n-dotierten plattenförmigen Silicium-Halbleiterkörper ausgegangen. Auf dessen eine Oberflächenseite werden gemäss der Fig. 1 Oxidationsmaskierungsschichten 1 aus Siliciumnitrid aufgebracht. Anstelle von einheitlichen Siliciumnitridschichten können auch Mehrschichtenstrukturen mit oben liegenden Siliciumnitridschichten 11 verwendet werden. Jedenfalls ist die Wahl der Materialien so zu treffen, dass die Oxidationsmaskierungsschichten 1 selektiv gegenüber den später noch aufzubringenden Ätzmaskierungsschichten 6 (vgl. Fig. 3) ätzbar sind.

Danach wird gemäss der Fig. 2 eine Photolackmaske 4 aufgebracht, welche den intrinsischen Basisbereich 2 ausspart bzw. definiert. Bei den anschliessend erfolgenden zwei Implantationsprozessen von p-dotierten Verunreinigungen, die in beliebiger Reihenfolge erfolgen können, wird die Anordnung gemäss der Fig. 2 erhalten. Dabei werden das eine Mal bei relativ geringer Baschleunigungsenergie Dotierungsionen in den freiliegenden äusseren extrinsischen Basisbereich 5 ausserhalb des Emitterbereichs 2 und das andere Mal bei relativ grosser Beschleunigungsenergie z.B. 100-200 keV, welche ausreicht, den Oxidationsmaskierungsschichtteil 1 zu durchdringen, Dotierungsionen gleichen Leitungstyps in den Gesamt-Basisbereich 3 einschliesslich des Emitterbereichs 2 implantiert. Vorzugsweise erfolgt die Implantation hoher Energie mit geringer Dosis von ca. $10^{12}$ bis $10^{13}$ cm$^{-2}$ und die Implantation relativ geringer Energie z.B. 10-100 keV bei demgegenüber wesentlich erhöhter Dosis, um einen niedrigen Basiswiderstand zu erhalten.

Anschliessend wird, nachdem die extrinsischen Basisbereiche 5 mit der Maskierungsschicht 6 durch thermische Oxidation bedeckt worden sind, die Halbleiterplatte einem Siliciumnitrid selektiv angreifenden Ätzmittel, insbesondere heisser Phosphorsäure, ausgesetzt, so dass die Oxidationsmaskierungsschichtteile 2 entfernt werden, wie die Fig. 3 veranschaulicht.

Die gegebenenfalls unter der Nitridschicht 11 liegende relativ dünne Si-Oxidschicht 12 der Oxidationsmaskierungsschicht kann durch kurzzeitiges Eintauchen in ein Si-Oxid-Ätzmittel selektiv entfernt werden.

Danach werden in die Oberfläche n-dotierende Verunreinigungen vom Leitungstyp der Emitterzone implantiert, wobei die Ätzmaskierungsschicht 6 als gegen die Implantation wirksame Maske verwendet wird. Es wird eine Implantation von n-dotierenden Ionen in einer relativ hohen Dosis von $10^{15}$ bis $10^{16}$ $cm^{-2}$ durchgeführt um einen hohem Emitterwirkungsgrad zu erhalten.

Nach der Implantation kann die gesamte Anordnung mit einer Fremdoxidschicht abgedeckt werden. Dann erfolgt die Basiszonendiffusion mit der Emitterzonendiffusion unter Aktivierung der Dotierungen.

Nach Anbringung der Emitterkontakte 9 und der Basiskontakte 10 werden nach der Zerteilung der Halbleiterplatte Planartransistoren gemäss der Fig. 4 erhalten, die einzeln in bekannter Weise kontaktiert und verkapselt werden.

Um niederohmige Kollektoranschlüsse zu realisieren, wird bei dem Verfahren der Erfindung eine n-dotierte Halbleiterplatte verwendet, die eine relativ niedrigdotierte Halbleiterschicht an der einen Oberflächenseite eines hochdotierten Substratkörpers aufweist.

## Patentansprüche

1. Verfahren zum Herstellen von bipolaren Planartransistoren an einer in die einzelnen Planartransistoren zu zerteilenden n-leitenden Halbleiterplatte, bei welchem Verfahren die extrinsischen Basiszonen durch Implantation von p-dotierenden Ionen hergestellt werden, dadurch gekennzeichnet,

— dass die Emitterbereiche mit Oxidationsmaskierungsschichtteilen (1; 11; 12) bedeckt werden,

— dass danach eine die Gesamt-Basisbereiche (3) definierende Photolackmaske (4) erzeugt wird,

— dass anschliessend in die freiliegenden äusseren extrinsischen Basisbereiche (5) bei einer relativ geringen Beschleunigungsspannung und relativ hoher Dosis p-dotierende Ionen implantiert werden und mit geringer Dosis Ionen gleichen Leitungstyps in die frei liegenden extrinsischen Basisbereiche (5) und in die übrigen Bereiche der Gesamt-Basisbereiche (3) bei einer so grossen Beschleunigungsspannung implantiert werden, dass die die Emitterbereiche (2) bedeckende Oxidationsmaskierungsschichtteile (1; 11, 12) durchdrungen werden,

— dass dann nach Entfernung der Photolackmaske (4) die extrinsischen Basisbereiche (5) mit gegen Ätzung der Oxidationsmaskierungsschichtteile (1; 11, 12) widerstandsfähigen Ätzmaskierungsschichten (6) bedeckt werden,

— dass sodann nach Abätzung der Oxidationsmaskierungsschichtteile (1; 11, 12) Dotierungen vom Leitungstyp der Emitterzonen (7) implantiert werden und sowohl die Basiszonen (8) als auch die Emitterzonen (7) unter Aktivierung der Dotierungen diffundiert werden,

— dass danach an den Emitterzonen (7) und den Basiszonen (8) je ein Kontaktfleck (9, 10) angebracht wird und die Halbleiterplatte in je ein ein Kontaktfleckpaar (9, 10) enthaltendes Halbleiterplättchen (11) zerteilt wird und

— dass schliesslich in bekannter Weise sowohl die einzelnen Kontaktfleckpaare (9, 10) als auch die die Kollektorzonen (11') bildenden Halbleiterplättchen (11) an der den Kontaktfleckpaaren (9, 10) abgelegenen Oberflächenseite der Halbleiterplättchen kontaktiert werden und die Halbleiterplättchen (11) einzeln umhüllt werden.

2. Verfahren nach Anspruch 1, dadurch gekennzeichnet, dass Oxidationsmaskierungsschichten (1) aus Siliciumnitrid verwendet werden und die Ätzmaskierungsschichten (6) durch thermische Oxidation der einen Halbleiteroberfläche der extrinsischen Basisbereiche (5) erzeugt werden.

3. Verfahren nach Anspruch 1 oder 2, dadurch gekennzeichnet, dass eine Halbleiteroberfläche eine hochohmige Halbleiterschicht aufweist, in die die Basiszonen (8) eingebracht werden.

## Claims

1. Method to manufacture bipolar planar transistors on a semiconductor wafer of the n-conductivity type, which is to be divided into the individual planar transistors, in which method the extrinsic base zones are produced by the implantation of p-doping ions, characterized in

— that the emitter areas are covered with oxidation masking layer portions (1; 11, 12),

— that thereafter there is produced a photoresist mask (4), defining the total-base areas (3),

— that thereafter to the exposed outer extrinsic base areas (5), at a relatively low accelerating voltage and a relatively high dose, p-doping ions are implanted and that in a small dose, ions of the same conductivity type are implanted into the exposed extrinsic base areas (5) and into the remaining total-base areas (3) at such a high accelerating voltage that the oxidation masking layer portions (1; 11, 12), covering the emitter areas (2), are penetrated,

— that then, following the removal of the photoresist mask (4), the extrinsic base areas (5) are covered with etch masking layers (6) which are resistive to the etching of the oxidation masking layer portions (1; 11, 12),

— that then, after the oxidation masking layer portions (1; 11, 12) have been etched away, dopings of the conductivity type of the emitter zones (7) are implanted and the base zones (8) as well as the emitter zones (7) are diffused by activating the dopings,

— that thereafter, to the emitter zones (7) and the base zones (8), there is attached one contact pad (9, 10) each, and that the semiconductor wafer is divided into semiconductor chips (11) each containing one pair of contact pads (9, 10), and

— that finally, in the manner known per se, the individual pairs of contact pads (9, 10) as well as the semiconductor chips (11) forming the collector zones (11'), are contacted on the surface side of the individual semiconductor chips not facing the pairs of contact pads (9, 10), and that then the semiconductor chips (11) are individually enveloped.

2. A method as claimed in claim 1, characterized in that oxidation masking layers (1) of silicon nitride are used, and that the etch masking layers (6) are produced by way of thermal oxidation of the one semiconductor surface of the extrinsic base areas (5).

3. A method as claimed in claim 1 or 2, characterized in that a semiconductor wafer is used which comprises on its one semiconductor surface a high-resistive semiconducting layer into which the base zones (8) are introduced.

## Revendications

1. Procédé de fabrication de transistors planar bipolaires sur une tranche de semi-conducteur à conductibilité de type N devant être divisée en transistors planar individuels, selon lequel les zones de base extrinsèques sont produites par implantation d'ions de dopage de type P, caractérisé en ce que

— les régions d'émetteurs sont recouvertes par des parties d'une couche de masquage d'oxydation (1; 11, 12),

— puis, un masque en laque photosensible (4) est réalisé, définissant les régions totales de base (3),

— ensuite, des ions de dopage de type P sont implantés dans les régions de base extrinsèques périphériques exposées, avec une tension d'accélération relativement faible et un dosage relativement élevé et des ions du même type de conductibilité sont implantés dans les régions de base extrinsèques exposées et dans le reste des régions de base totales (3) avec un dosage plus faible et une tension d'accélération suffisamment forte pour que les parties de couche de masquage d'oxydation (1; 11, 12) couvrant les zones d'émetteurs soient traversées,

— puis, après enlèvement du masque en laque photosensible (4), les régions de base extrinsèques sont recouvertes d'une couche de masque d'attaque chimique (6) qui résiste à l'attaque chimique des parties de couche de masquage d'oxydation (1; 11, 12),

— puis, après l'élimination par attaque chimique des parties de couche de masquage d'oxydation (1; 11, 12), des dopants du type de conductibilité des zones d'émetteurs (7) sont implantés et les zones de base (8), en même temps que les zones d'émetteurs (7), sont diffusées par activation des dopants,

— puis, une plate-forme de contact (9, 10) est attachée à chacune des zones d'émetteurs (7) et des zones de bases (8), et la tranche de semi-conducteur est divisée en puces de semi-conducteur (11), chacune contenant une paire de ces plates-formes (9, 10), et

— finalement, d'une manière connue en elle-même, les paires de plates-formes de contact individuelles (9, 10), de même que les puces de semi-conducteur (11) formant les zones de collecteurs (11'), sont raccordées, du côté de la surface des puces de semi-conducteur où sont disposées les paires de plates-formes de contact (9, 10), puis les puces de semi-conducteur (11) sont ensuite individuellement encapsulées.

2. Procédé selon la revendication 1, caractérisé en ce que les couches de masquage d'oxydation (1) sont en nitrure de silicium et en ce que les couches de masquage d'attaque chimique (6) sont produites par oxydation thermique de la surface de semi-conducteur des régions de base extrinsèques (5).

3. Procédé selon la revendication 1, ou 2, caractérisé en ce que la tranche de semi-conducteur utilisée comprend, sur une surface de semi-conducteur, une couche de semi-conducteur à haute résistivité dans laquelle sont introduites des zones de base (8).

FIG.1

1 → 

2 11 12

n

FIG.2

4 11 12 4

3

5 5

n

FIG.3

6 7 8 6

$n^+$

$p^+$ $p^-$ $p^+$

n

FIG.4

9 7 10

$p^+$ $p^+$

8

$11^I$ 11